# EUROPEAN PATENT SPECIFICATION

(11) **EP 2 287 596 B1**
(45) Date of publication and mention of the grant of the patent: **19.03.2014**
(21) Application number: 09010327.6
(22) Date of filing: 11.08.2009
(51) Int. Cl.: G01N 27/12

(54) **Sensor with glob-top and method for manufacturing the same**
Sensor mit Glob-Top und Herstellungsverfahren dafür
Capteur avec glob-top et son procédé de fabrication

(43) Date of publication of application: 23.02.2011
(73) Proprietor: Sensirion AG, 8712 Stäfa (CH)
(72) Inventor: Graf, Markus, 8005 Zürich (CH); Niederberger, Dominik, 8055 Zürich (CH); Hunziker, Werner, 8712 Stäfa (CH); Morf, Peter, 8052 Zürich (CH); Hummel, René, 6340 Baar (CH)
(74) Representative: Sutter, Kurt

(56) References cited:
- WO-A1-98/05935
- WO-A1-2006/114005
- WO-A1-2007/012992
- WO-A2-01/40784
- WO-A2-02/48702
- US-A- 5 219 712
- US-A1- 2005 031 490
- US-B1- 6 566 745

## Description

### Technical Field

The invention relates to a sensor having a substrate, which is covered in part by a glob of hardened material, and to a method for manufacturing such a sensor.

### Background Art

Integrated sensors typically comprise a substrate, such as a semiconductor chip, with a sensor device arranged on a surface thereof. Such sensors can e.g. be "packaged" using the so-called "glob-top" technology, where a glob or drop of resin is placed on the surface of the substrate and covers the bond wires. The glob protects the bond wires and substrate and also provides or improves the mechanical connection between the substrate and an underlying support, such as a printed circuit board.

If the sensor comprises a sensor device that needs to be in contact with the environment, e.g. if the sensor device is a humidity sensor or a substance sensor, applying the glob becomes difficult since the glob must not cover the sensor device.

US 2005/031490 A1 discloses an analysis device that may be used in biochemical analyses which device includes a module in a first housing, including a chip support, a sensor chip and electrical contacts between the chip and the chip support. The chip is encapsulated so that the electrical contacts are insulated and the sensitive surface of the sensor chip remains accessible to a fluid to be tested. A polyimide ring 27 in form of a dam serves as delimitation of the sensitive surface with respect to the encapsulation.

US 6,566,745 Bl is related to an image sensor packaging technique based on a Ball Grid Array (BGA) IC packaging technique, further referred to as image sensor ball grid array (ISBGA). A transparent cover is attached to a semiconductor substrate. Depending on the method of attaching the cover to the substrate a hermetic or non-hermitic sealing is obtained. The obtained structure can be connected trough wire-bonding or flip chip connection. Deposition of a dam prevents the optical sensing area from being covered with polymeric sealant during a glob top deposition.

In WO 2007/012992 A1 a package for a microelectronic component is disclosed, comprising a carrier element having a first side that comprises conductor lines, a microelectronic component having a first surface and a second surface facing away from the first surface, the microelectronic component with said second surface being mounted on said first side of said carrier element and connected to the conductor lines via bonding wires, a polymeric encapsulation material encapsulating the bonding wires and exposing a central zone of said first surface of said microelectronic component, the encapsulation material comprising an outer edge at said first side of the carrier element and an inner edge at said first surface of said microelectronic component, a dam on the carrier device abutting to the encapsulation material. The dam influences the forming of the outer and the inner edge during manufacturing the encapsulation material and enlarges the area of the central zone.

WO 01/40784 A2 relates to a sensor for measuring the parameters of a fluid, in particular, for detecting the presence of substances contained in a gas. The sensor comprises a measuring device that is placed on a semiconductor chip which is protected by a housing. A partition of the housing divides the semiconductor chip into two parts. The first part is connected to the exterior via openings in the housing and carries the measureing device. The second part is covered by a hardened sealing material. The sealing material protects the semiconductor chip from undesirable environmental influences. The partition forms a capillary between the chip and the housing, the capillary action thereof draws in the sealing material, and the end thereof stops the sealing material.

### Disclosure of the Invention

The problem to be solved by the present invention is therefore to provide a method and a sensor that make it easier to use glob-top technology for sensors that need to be in contact with their environment.

This problem is solved by the method and sensor according to the independent claims.

Accordingly, an auxiliary layer is arranged on the substrate and structured to form at least one edge, which edge extends along at least part of a (virtual) border dividing the first surface, i.e. the surface into which the sensor device has been integrated, into a first and a second section. The sensor device is at least partially arranged in the first section. A glob of hardening material, such as a hardening resin, is applied to at least part of the second section and the edge is used as a stop for preventing the glob from entering the first section. In other words, while applying the glob to the second section, it expands laterally (i.e. in a direction parallel to the surface) until it meets the edge of the auxiliary layer, where it is typically stopped. This is presently understood to be a consequence of surface tension (capillary) effects, but, depending on the used materials, different wetting properties may also play a role. Once the glob is properly positioned, it can be hardened.

The sensor manufactured in this way will comprise: a substrate with the sensor device integrated on its first side; the structured auxiliary layer arranged on the first side and having said edge extending along the border dividing the first and second sections of the surface; and the glob of hardened material covering at least part of the second section, with an edge of the glob extending along the edge of the auxiliary layer.

Advantageously, the auxiliary layer is structured photolithographically. It can e.g. be a photoresist because, on the one hand, structuring a photoresist is a well-known technique, and, on the other hand, resins, or, more generally, organic materials, have been found to be suited as a good stop for the glob material.

The present invention is especially well suited for substance sensors, such as humidity sensors, whose sensor device must not be covered by the glob-top, but it e.g. can also be applied to optical sensors, flow sensors or other sensor types.

Also, the invention is well suited for being used with even very small sensor substrates as it exploits surface tension effects.

Other advantageous embodiments are listed in the dependent claims as well as in the description below.

### Brief Description of the Drawings

The invention will be better understood and objects other than those set forth above will become apparent from the following detailed description thereof. Such description makes reference to the annexed drawings, wherein:
Fig. 1 is a sectional view of a wafer prior to applying the auxiliary layer,
Fig. 2 shows the wafer of Fig. 1 after application of the auxiliary layer,
Fig. 3 shows the wafer of Fig. 2 after structuring the auxiliary layer,
Fig. 4 shows a single support after dicing and after applying the glob-top,
Fig. 5 shows a top view of the support of Fig. 4 (without glob-top)
Fig. 6 is a top view of a support of a second embodiment of the invention,
Fig. 7 is a top view of a support of a third embodiment of the invention, and
Fig. 8 is a top view of a support of a fourth embodiment of the invention.

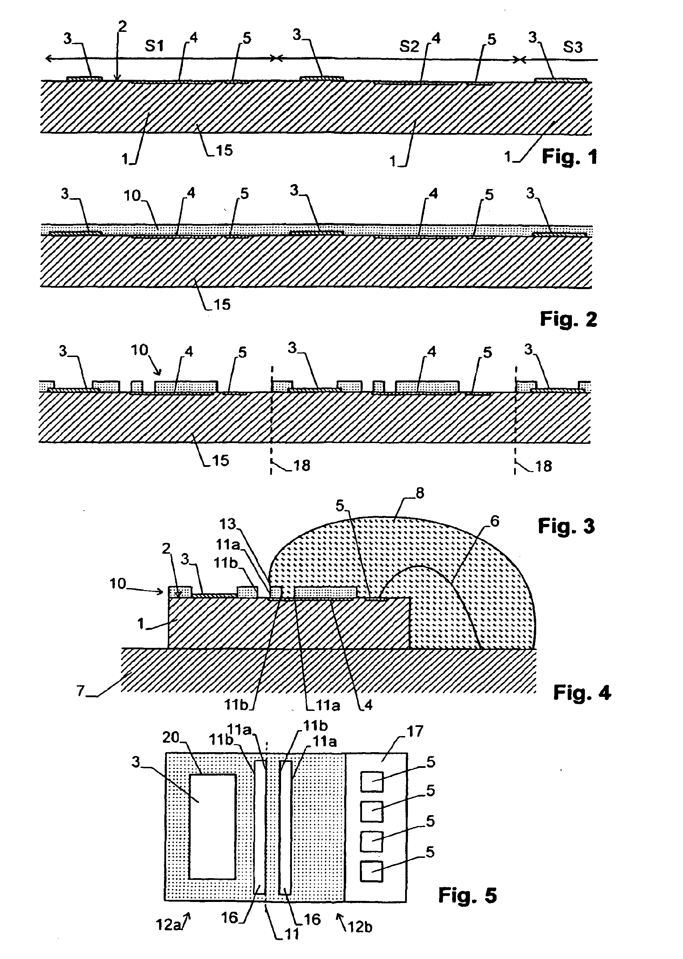

Note: The figures are not to scale. Figs. 5 through 8 show the auxiliary layer with a dotted pattern.

### Modes for Carrying Out the Invention

Overview:
Figs. 1 - 5 show the manufacturing steps of a humidity sensor according to an embodiment of the invention. The procedure is probably best understood when first referring to Fig. 4, which shows a sectional view of the sensor after its manufacturing process has been completed.

The sensor of Fig. 4 comprises a substrate 1, which is a semiconductor substrate. Substrate 1 has a first surface 2, namely its top surface in Fig. 4. Substrate 1 carries a sensor device 3 on its surface 2. Sensor device 3 can e.g. be a moisture adsorbing film, such as a porous polymer, whose dielectric constant varies with environmental humidity. An arrangement of electrodes, such as a set of interdigital electrodes integrated below the film, allows to determine the humidity by means of a capacitive measurement. A device of this type is e.g. described in US 6690569.

In addition to sensor device 3, substrate 1 can carry further elements in its surface 2, such as an integrated circuitry 4, which can e.g. comprise digital and/or analogue processing and/or control circuits. It must be noted, though, that the invention may also be carried out with devices not having any integrated circuitry.

The sensor further comprises a set of contact pads 5, which are also integrated on surface 2, for electrically connecting the circuitry 4 and/or sensor device 3 to bond wires 6. The bond wires 6 can, in turn, be connected to electrical leads on a support 7, such as a printed circuit board.

A glob 8 of hardening material is applied to first surface 2 as well as to support 7. It covers the bond wires 6.

The sensor further comprises an auxiliary layer 10 applied to first surface 2. In the finished product, as shown in Fig. 4, auxiliary layer 10 is structured to form one or more edges 11a, 11b, which traverse at least part of first surface 2. Each edge extends along at least part of a border or border line 11, as shown in Fig. 5, which separates surface 2 into a first and a second section 12a, 12b, respectively. Sensor device 3 is located in part or completely in first section 12a, while glob 8 covers at least part of second section 12b. An edge 13 of glob 8 extends along at least part of one of the edges 11a or 11b.

Manufacturing process:
In the following, the manufacturing process of the embodiment of the sensor shown in Fig. 4 is described by reference to Figs. 1 - 5.

In a first step, a wafer 15 is provided, which comprises a plurality of the substrates 1 that will later be cut from the wafer in order to form the individual sensors. The regions of three of the individual sensors are marked in Fig. 1 by S1, S2, and S3. Each substrate 1 on wafer 15 carries at least one of the sensor devices 3 on its first surface 2, and circuitry 4 as well as the bond pads 5 have also been applied thereto, e.g. using conventional CMOS manufacturing technology.

In a next step, as shown in Fig. 2, wafer 15 and, therefore, each substrate 1 is covered by auxiliary layer 10. At first, auxiliary layer 10 covers each substrate 1 completely. Advantageously, auxiliary layer 10 is a photoresist, in particular SU-8. However, it can also be any other type of material that can be structured after its application to wafer 15. Materials allowing structuring by means of photolithography are advantageous because photolithography is typically also used for creating the other structures on substrate 1, thus the structuring of auxiliary layer 10 can be integrated efficiently and accurately in the manufacturing process of the sensor.

Now, auxiliary layer 10 is structured on wafer 15. The purpose of the structuring process is to form the edges 11a, 11b mentioned above, as well as some additional structures. The edges 11a, 11b are created by removing a plurality of substantially parallel, strip-shaped regions 16 from auxiliary layer 10 (see Fig. 5). In addition, a region 17 at the location of the contact pads 5 and at least part of auxiliary layer 10 over sensor device 3 are removed.

Now, after structuring auxiliary layer 10, wafer 15 can be diced (cut) along lines 18 into the individual sensors S1, S2, S3, etc.

In a next step, as shown in Fig. 4, each substrate 1 is placed on a support 7 and can e.g. be glued thereto, and bond wires 6 are attached to the bond pads 5 of substrate 1 as well as to the leads on support 7.

Then, glob 8 is (in liquid form) applied to the second region 12b of surface 2 as well as to the support 7 adjacent thereto, thereby covering the bond wires 6. While still in its liquid state, glob 8 will expand laterally and approach sensor device 3. However, as described above, its forward edge 13 will in most cases be stopped when reaching the first edge 11a of auxiliary layer 10. If it is not stopped there, it may expand further until it reaches a next edge of auxiliary layer 10, where the probability of the glob expansion to be stopped is even higher. Hence, if an appropriate amount of glob material is applied, the glob will be stopped at one of the edges 11a, 11b and not cover sensor device 3.

Now, glob 8 can be hardened. To achieve hardening, the material of glob 8 is advantageously a resin that is crosslinked after its application to substrate 1. For example, the following material can be used: Hysol EO1062, Hysol FP4450 (Henkel); and Stycast 50300 (National Starch and Chemical Company).

Depending on the material used for glob 8 and its wetting properties in respect to auxiliary layer 10 as well as the wetting properties of glob 8 in respect to the material of surface 2, the expansion of glob 8 will either be stopped at a "negative edge" 11a or at a positive edge 11b of auxiliary layer 10. If, for example, a resin is used for glob 8 and SU-8 is used for auxiliary layer 10, while the surface 2 is of silicon oxide or silicon nitride, expansion generally stops at a negative edge 11a (i.e. at a transition from the auxiliary layer to the material of surface 2).

Advantageously, auxiliary layer 10 should be an organic material, such as a resin or other polymer, while surface 2 is of an inorganic material, such as silicon nitride, silicon oxide or glass, or a mixture of such materials.

In addition, to further improve the stopping action of auxiliary layer 10, it should be thick in order to create a high step at the edges 11a, 11b. Advantageously, the thickness is at least 5 µm, in particular at least 10 µm.

Shape, number and position of edges:
The shape, position and number of the edges 11a, 11b can be varied depending on available space and desired shape of glob 8.

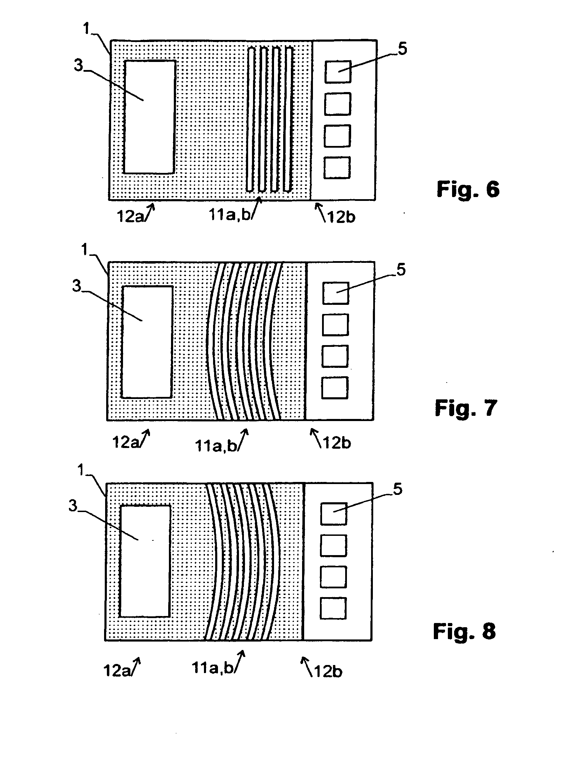

Fig. 6 shows an embodiment of a sensor having a larger number of edges 11a, 11b closer to the bond pads 5.
Fig. 7 is an embodiment having curved edges 11a, 11b thus that second section 12b has a convex border line.
Fig. 8 is an embodiment also having curved edges 11a, 11b, but with a curvature giving rise to a concave border line of second section 12b.

Alternative packaging:
WO 2006/114005 describes a method for packaging a sensor in a moulded housing where the mould is provided with an inward projecting section that abuts against a buffer structure during the injection-process. In the embodiment of Figs. 1 - 6 of that application, which are incorporated by reference herein, the buffer structure forms a frame around the sensor device.

Advantageously, the auxiliary layer 10 of the present invention acts as such a buffer structure and also forms a frame 20 around sensor device 3, thus making it possible to package the sensor either in the manner as shown in Fig. 4 of the present application, or in the manner as shown in Fig. 6 of WO 2006/114005.

The term "forming a frame around the sensor device" is to be understood such that the auxiliary layer, i.e. the buffer structure, extends continuously around an opening located above the sensor device.

Notes:
In the example above, a plurality of parallel edges 11a, 11b has been formed in auxiliary layer 10. This has the advantage of redundancy, i.e. when one edge fails to stop the still liquid glob 8, a next edge may still succeed to do so. For that reason, the edges are advantageously substantially parallel to each other.

Even though the above description explains the invention with reference to a humidity sensor, it must be noted that the same technology can also be applied to other types of sensors, such as flow sensors (where sensor device 3 is a flow sensor device, such as a thermal flow sensor device) or light sensors (where sensor device 3 is an optical detector).

## Claims

1. A method for manufacturing a sensor comprising the steps of
providing a semiconductor substrate (1) having at least one sensor device (3) on a first surface (2),
covering said substrate (1) with an auxiliary layer (10),
structuring said auxiliary layer (10), by removing part of said auxiliary layer (10), in order to form at least one edge (11a, 11b) in said auxiliary layer, wherein said edge (11a, 11b) extends along at least part of a border (11) dividing said first surface (2) into a first and a second section (12a, 12b), wherein said sensor device (3) is at least partially arranged in said first section (12a),
applying a glob (8) of hardening material to at least part of said second section (12b) while using said edge (11a, 11b) in form of a transition from the auxiliary layer (10) to a material of the surface (2) as a stop for preventing said glob (8) from entering said first section (12a), and
hardening said glob (8).

2. The method of claim 1 wherein said step of structuring said auxiliary layer (10) is carried out photolithographically.

3. The method of any of the preceding claims wherein said auxiliary layer (10) is a polymer, in particular a resin.

4. The method of claim 3 wherein said layer is a photoresist, in particular SU-8.

5. The method of any of the preceding claims comprising the step of forming a several edges (11a, 11b) of said auxiliary layer (10) on said substrate (1), wherein said edges (11a, 11b) are substantially parallel.

6. The method of claim 5 wherein said edges (11a, 11b) are formed by removing a plurality of stripshaped, substantially parallel regions (16) of said auxiliary layer (10).

7. The method of any of the preceding claims further comprising the step of removing at least part of said auxiliary layer (10) covering said sensor device (3) when structuring said auxiliary layer (10).

8. The method of any of the preceding claims comprising the steps of
providing a plurality of said substrates (1) as a wafer (15),
covering said substrates (1) with said auxiliary layer (10) by covering said wafer (15),
structuring said auxiliary layer (10) on said wafer (15), and
dicing said wafer (15) into the individual substrates (1) after structuring said auxiliary layer (10).

9. The method of any of the preceding claims further comprising the steps of attaching bond wires (6) to said substrate (1) and covering said bond wires (6) by said glob (8).

10. The method of any of the preceding claims wherein the first surface (2) of said substrate (1) is of an inorganic material, in particular a material comprising at least one of the group of silicon nitride, silicon oxide and glass.

11. The method of any of the preceding claims further comprising the steps of
arranging said substrate (1) on a support (7) and
applying said glob (8) to said first surface (2) as well as to said support (7).

12. The method of any of the preceding claims wherein a thickness of said auxiliary layer (10) is at least 5 µm, in particular at least 10 µm.

13. A sensor, in particular as manufactured by the method of any of the preceding claims, comprising
a semiconductor substrate (1),
a sensor device (3) integrated on a first surface (2) of said substrate (1),
a structured auxiliary layer (10) arranged on said first surface (2), said auxiliary layer (10) comprising at least one edge (11a, 11b) extending along at least part of a border (11), wherein said border (11) divides said first surface (2) into a first and a second section (12a, 12b), wherein said sensor device (3) is arranged in said first section (12a), and
a glob (8) of hardened material covering at least part of said second section (12b) and covering the auxiliary layer (10) in said second section (12b), wherein an edge (13) of said glob (8) extends along said edge (11a, 11b) of said auxiliary layer (10).

14. The sensor of claim 13 wherein said auxiliary layer (10) is a structured photoresist.

15. The sensor of any of the claims 13 or 14 wherein said sensor is a humidity sensor.

16. The sensor of any of the claims 13 to 16 wherein said auxiliary layer (10) forms a frame (20) around said sensor device (3).

## Patentansprüche

1. Ein Verfahren zur Herstellung eines Sensors, umfassend die Schritte:
- Bereitstellen eines Halbleitersubstrats (1) mit mindestens einer Sensorvorrichtung (3) auf einer ersten Oberfläche (2),
- Bedecken des Substrats (1) mit einer Hilfsschicht (10),
- Strukturieren der Hilfsschicht (10), indem ein Teil der Hilfsschicht (10) abgetragen wird, um mindestens eine Kante (11a, 11b) in der Hilfsschicht (10) zu bilden, wobei sich die Kante (11a, 11b) entlang mindestens eines Teils einer Grenze (11), die die erste Oberfläche (2) in einen ersten und in einen zweiten Bereich (12a, 12b) teilt, erstreckt, wobei die Sensorvorrichtung (3) mindestens teilweise im ersten Bereich (12a) angeordnet ist,
- Auftragen eine Vergussmasse (8) eines Aushärtungsmaterials auf mindestens einen Teil des zweiten Bereichs (12b), wobei die Kante (11a, 11b) in der Form eines Übergangs von der Hilfsschicht (10) zu einem Material der Oberfläche (2) als eine Sperre verwendet wird, um zu verhindern, dass die Vergussmasse (8) in den ersten Bereich (12a) dringt, und
- Härten der Vergussmasse (8).

2. Das Verfahren nach Anspruch 1, wobei der Schritt der Strukturierung der Hilfsschicht (10) mit Fotolithographie ausgeführt wird.

3. Das Verfahren nach einem der vorangehenden Ansprüche, wobei die Hilfsschicht (10) ein Polymer, insbesondere ein Harz, ist.

4. Das Verfahren nach Anspruch 3, wobei die Schicht eine Fotolackschicht ist, insbesondere SU-8.

5. Das Verfahren nach einem der vorangehenden Ansprüche, umfassend den Schritt der Bildung einer Vielzahl von Kanten (11a, 11b) der Hilfsschicht (10) auf dem Substrat (1), wobei die Kanten (11a, 11b) im Wesentlichen parallel sind.

6. Das Verfahren nach Anspruch 5, wobei die Kanten (11a, 11b) durch Abtragung einer Vielzahl von streifenförmigen, im Wesentlichen parallelen Bereichen (16) der Hilfsschicht (10) gebildet werden.

7. Das Verfahren nach einem der vorangehenden Ansprüche, weiter umfassend den Schritt der Abtragung mindestens eines Teils der Hilfsschicht (10), die die Sensorvorrichtung (3) bedeckt, während der Strukturierung der Hilfsschicht (10).

8. Das Verfahren nach einem der vorangehenden Ansprüche, umfassend die Schritte
- Bereitstellen einer Vielzahl von Substraten (1) als ein Wafer (15),
- Bedecken des Substrats (1) mit der Hilfsschicht (10) durch Bedecken des Wafers (15),
- Strukturieren der Hilfsschicht (10) auf dem Wafer (15), und
- Vereinzeln des Wafers (15) in die einzelnen Substrate (1) nach der Strukturierung der Hilfsschicht (10).

9. Das Verfahren nach einem der vorangehenden Ansprüche, weiter umfassend die Schritte der Befestigung von Bonddrähten (6) am Substrat (1) und Bedecken der Bonddrähte (6) mit der Vergussmasse (8).

10. Das Verfahren nach einem der vorangehenden Ansprüche, wobei die erste Oberfläche (2) des Substrats (1) aus anorganischem Material gebildet ist, insbesondere aus einem Material umfassend mindestens ein Element der Gruppe: Siliziumnitrid, Siliziumoxid und Glas.

11. Das Verfahren nach einem der vorangehenden Ansprüche, weiter umfassend die Schritte
- Anordnen des Substrats (1) auf einem Träger (7) und
- Aufbringen der Vergussmasse (8) auf die erste Oberfläche (2) sowie auf den Träger (7).

12. Das Verfahren nach einem der vorangehenden Ansprüche, wobei eine Dicke der Hilfsschicht (10) mindestens 5 µm, insbesondere mindestens 10 µm, beträgt.

13. Ein Sensor, insbesondere hergestellt mittels des Verfahrens nach einem der vorangehenden Ansprüche, umfassend
ein Halbleitersubstrat (1),
eine Sensorvorrichtung (3), die auf einer ersten Oberfläche (2) des Substrats (1) integriert ist,
eine strukturierte Hilfsschicht (10), die auf der ersten Oberfläche (2) angeordnet ist, wobei die Hilfsschicht (10) mindestens eine Kante (11a, 11b) umfasst, die sich entlang mindestens eines Teils einer Grenze (11) erstreckt, wobei die Grenze (11) die erste Oberfläche (2) in einen ersten und in einen zweiten Bereich (12a, 12b) teilt, wobei die Sensorvorrichtung (3) im ersten Bereich (12a) angeordnet ist, und
eine Vergussmasse (8) aus gehärtetem Material, die mindestens einen Teil des zweiten Bereichs (12b) bedeckt und die Hilfsschicht (10) im zweiten Bereich (12b) bedeckt, wobei sich eine Kante (13) der Vergussmasse (8) entlang der Kante (11a, 11b) der Hilfsschicht (10) erstreckt.

14. Der Sensor nach Anspruch 13, wobei die Hilfsschicht (10) eine strukturierte Fotolackschicht ist.

15. Der Sensor einem der Ansprüche 13 oder 14, wobei der Sensor ein Feuchtigkeitssensor ist.

16. Sensor nach einem der Ansprüche 13 bis 15, wobei die Hilfsschicht (10) einen Rahmen (20) um die Sensorvorrichtung (3) bildet.

## Revendications

1. Méthode pour fabriquer un capteur, comprenant les étapes de
- fournir un substrat semi-conducteur (1) avec au moins un dispositif capteur (3) sur une première surface (2),
- couvrir ledit substrat (1) avec une couche auxiliaire (10),
- structurer ladite couche auxiliaire (10) en enlevant une partie de ladite couche auxiliaire (10) afin de former au moins un bord (11a, 11b) dans ladite couche auxiliaire, ledit bord (11a, 11b) s'étendant le long d'au moins une partie d'une bordure (11) qui divise ladite première surface (2) dans une première et une deuxième section (12a, 12b), ledit dispositif capteur (3) étant au moins partiellement arrangé dans ladite première section (12a),
- appliquer un morceau (8) de matériau durcissable à au moins une partie de ladite section (12b) en utilisant ledit bord (11a, 11b) en forme d'une transition de la couche auxiliaire (10) à un matériau de la surface (2) comme arrêt pour éviter que ledit morceau (8) entre dans la première section (12a), et
- écrouir ledit morceau (8).

2. La méthode selon la revendication 1, ladite étape de structurer ladite couche auxiliaire (10) étant effectuée de manière photo-lithographique.

3. La méthode selon l'une des revendications précédentes, ladite couche auxiliaire (10) étant un polymère, particulièrement une résine.

4. La méthode selon la revendication 3, ladite couche étant une photorésine, particulièrement SU-8.

5. La méthode selon l'une des revendications précédentes, comprenant l'étape de former une pluralité de bords (11a, 11b) de ladite couche auxiliaire (10) sur ledit substrat (1), les bords (11a, 11b) étant essentiellement parallèle.

6. La méthode selon la revendication 5, lesdits bords (11a, 11b) étant formés en enlevant une pluralité des régions (16) essentiellement parallèles et en forme de bande de ladite couche auxiliaire (10).

7. La méthode selon l'une des revendications précédentes, en outre comprenant l'étape d'enlever au moins une partie de ladite couche auxiliaire (10) qui couvre ledit dispositif capteur (3) pendant que la couche auxiliaire (10) soit structurée.

8. La méthode selon l'une des revendications précédentes, comprenant les étapes de
- fournir une pluralité de substrats (1) comme une plaquette (15),
- couvrir lesdits substrats (1) avec ladite couche auxiliaire (10) en couvrant ladite plaquette (15),
- structurer ladite couche auxiliaire (10) sur ladite plaquette (15), et
- découper ladite plaquette (15) dans des substrats (1) individuels après avoir structuré ladite couche auxiliaire (10).

9. La méthode selon l'une des revendications précédentes, en outre comprenant les étapes d'attacher des fils de connexion (6) audit substrat (1) et de couvrir lesdits fils de connexion (6) par ledit morceau (8).

10. La méthode selon l'une des revendications précédentes, la première surface (2) dudit substrat (1) étant un matériau inorganique, particulièrement un matériau comprenant au moins un du groupe: nitrure de silicium, oxyde de silicium et verre.

11. La méthode selon l'une des revendications précédentes, en outre comprenant les étapes
arranger ledit substrat (1) sur un support (7) et
appliquer ledit morceau (8) à ladite surface (2) ainsi qu'audit support (7).

12. La méthode selon l'une des revendications précédentes, un épaisseur de ladite couche auxiliaire (10) étant au moins 5 µm, particulièrement au moins 10 µm.

13. Un capteur, particulièrement fabriqué avec la méthode selon l'une des revendications précédentes, comprenant
un substrat semi-conducteur (1),
un dispositif capteur (3) intégré sur une première surface (2) dudit substrat (1),
une couche auxiliaire structurée (10) arrangée sur ladite première surface (2), ladite couche auxiliaire (10) comprenant au moins un bord (11a, 11b) s'étendant le long d'au moins une partie d'une bordure (11), ladite bordure (11) divisant ladite première surface (2) dans une première et une deuxième section (12a, 12b), ledit dispositif capteur (3) étant arrangé dans ladite première section (12a), et
un morceau (8) de matériau durcissable couvrant au moins une partie de ladite deuxième section (12b) et couvrant la couche auxiliaire (10) dans ladite deuxième section (12b), un bord (13) dudit morceau (8) s'étendant le long dudit bord (11a, 11b) de ladite couche auxiliaire (10).

14. Le capteur selon la revendication 13, ladite couche auxiliaire (10) étant une photorésine structurée.

15. Le capteur selon la revendication 13 ou 14, ledit capteur étant un capteur d'humidité.

16. Le capteur selon l'une des revendications 13 à 15, ladite couche auxiliaire (10) formant un cadre (20) autour dudit dispositif capteur (3).
